# EUROPEAN PATENT APPLICATION

(11) **EP 4 394 501 A1**
(43) Date of publication of application: **03.07.2024**
(21) Application number: 22861339.4
(22) Date of filing: 23.08.2022
(51) Int. Cl.: G03F 1/62

(54) **EXPOSURE PELLICLE CAPABLE OF ADJUSTING ATMOSPHERIC PRESSURE AT HIGH SPEED**

(30) Priority: 25.08.2021 JP 2021136785
(71) Applicant: SHIN-ETSU CHEMICAL CO., LTD., Tokyo 1000005 (JP)
(72) Inventor: KUBOTA, Yoshihiro, Annaka-shi, Gunma 379-0127 (JP); YANASE, Yu, Annaka-shi, Gunma 379-0127 (JP); TAKEUCHI, Ayano, Annaka-shi, Gunma 379-0127 (JP); NISHIMURA, Akinori, Annaka-shi, Gunma 379-0127 (JP); NOZAKI, Satoshi, Annaka-shi, Gunma 379-0127 (JP)
(74) Representative: Meissner Bolte Partnerschaft mbB
(86) International application number: PCT/JP2022/031648
(87) International publication number: WO 2023/027051

(57) **Abstract**

[Object] To improve the performance of a filter for a vent hole, which penetrates a pellicle frame, in response to the severe conditions of use required especially in EUV exposure. [Solution] A pellicle according to the present invention includes: a pellicle frame; an ultra-thin pellicle film provided on an upper end surface of the pellicle frame; a vent hole provided in the pellicle frame; and a filter that closes the vent hole. The filter includes a sheet composed partly or entirely of at least one of nanofibers and carbon nanotubes, and a support having openings and supporting the sheet.

## Description

### Technical Field

The present invention relates to a pellicle for exposure, in particular an EUV pellicle, which protects an exposure mask, used in the manufacturing of a semiconductor device, a liquid crystal display, or the like, from foreign matter and which is capable of high-speed adjustment of atmospheric pressure.

### Background Art

In the manufacturing of a semiconductor device, a liquid crystal display, or the like, a circuit pattern is formed by a so-called lithography technique using an exposure mask. In recent years, particularly in semiconductor devices, circuit patterns have become finer from micrometers to submicrometers and further to nanometers, and exposure light sources have changed accordingly to shorter-wavelength ones: g-line (436 nm), i-line (365 nm), KrF excimer laser (248 nm), and ArF excimer laser (193 nm). Even shorter-wavelength EUV (extreme ultraviolet, 13.5 nm) exposure has been studied these days, and has begun to be put into practice in some leading-edge devices.

Generally, in the manufacturing of a semiconductor device such as an LSI or a VLSI, after applying a resist to a wafer, the wafer, together with an exposure mask with a desired circuit pattern drawn thereon, is placed in an exposure machine, the exposure mask is irradiated by light, and the circuit pattern is transferred onto the wafer. These operations are usually performed in a clean room where the amount of dust has been reduced as much as possible. Nevertheless, dust from the human body, devices, or the environment often adheres to a mask upon its movement or setting after its production. Such dust is transferred together with a circuit pattern, and therefore an abnormal circuit will be formed. Thus, the resulting semiconductor device is a defective product, leading to a decrease in the manufacturing yield.

To avoid this problem, it is common practice to attach a dust-proof pellicle to a mask immediately after its production, as disclosed in Patent Document 1. This is because once a pellicle is attached to a mask, then dust will not directly land on a circuit pattern on the mask. Dust may land on a pellicle. Thus, by focusing an exposure beam on the circuit pattern, the dust on the pellicle will be "out of focus" and will not be transferred.

In general, a pellicle basically includes a metal frame, a pellicle film which is stretch-mounted on the upper end surface of the frame and which is highly transparent and resistant to light at an exposure wavelength, a hermetic seal formed on the lower end surface of the frame and made of an agglutinant having a relatively high light resistance, such as an acrylic resin or a silicone resin, and a filter for a vent hole which adjusts the pressure difference between the inside and outside of the pellicle after it is mounted to a mask.

The pellicle film may be made of a material which has a high permeability and a high resistance to light at an exposure wavelength. The material may be, for example, nitrocellulose for g-line (436 nm), cellulose propionate for i-line (365 nm), or an amorphous fluoropolymer for KrF excimer laser (248 nm) or ArF excimer laser (193 nm). With the progress toward finer circuits, the wavelength of exposure light is becoming increasingly shorter, and EUV (extreme ultraviolet, 13.5 nm) exposure has begun to be used recently. In principle, any material that is highly permeable and highly resistant to EUV light can be used for a pellicle film for EUV exposure; however, an organic material cannot withstand any more practically, and an inorganic material is generally preferred. In particular, monocrystalline silicon, polycrystalline silicon, or amorphous silicon, or a nitride, oxynitride, or carbide thereof, or a metal silicide such as molybdenum silicide is preferred because such a material can form a uniform film at low cost with good reproducibility. A pellicle film is also available which, in order to protect such a film material, has a protective film made of, for example, SiC, SiO₂, Si₃N₄, SiON, Y₂O₃, YN, Mo, Ru, or Rh. The above films, which have a submicron or smaller thickness to achieve a high permeability, have been studied, and some of them have already been put into practical use.

In conventional pellicles for g-line (436 nm), i-line (365 nm), KrF excimer laser (248 nm), ArF excimer laser (193 nm), or the like, which are used under atmospheric pressure, a non-woven fabric of PET, PTFE, or the like, having a fiber diameter of a few tens of micrometers to several hundred micrometers, is generally used as a filter for a vent hole.

### Citation List

### Patent Document

Patent Document 1: Japanese Patent Laid-Open Publication No. 2005-268464

### Non-Patent Document

Non-Patent Document 1: "Electronic Materials", July 1997 issue, p. 103

### Summary of Invention

### Technical Problem

On the other hand, in the case of pellicles for EUV (extreme ultraviolet: 13.5 nm) exposure that has begun to be actually used recently, which are used under vacuum or reduced pressure, a conventional filter made of a resin such as PET or PTFE, or a porous sintered metal or ceramic is used or proposed as a filter for a vent hole in some pellicles. However, in the present situation, there is almost no filter that can meet various dimensional limitations due to the structure of an exposure apparatus and can withstand the severe conditions of use, which is a major obstacle to practical use of EUV (extreme ultraviolet: 13.5 nm) exposure. In particular, current filters, composed of a non-woven fabric made of a resin such as PET or PTFE and comprising thick fibers, and a support comprising a mesh of woven metal fibers, are inevitably large and thick, and often cause problems such as being unusable due to the above-described dimensional limitations, narrowing of the usage area of an exposure mask, etc. In addition, such filters entail a high pressure loss, and have the drawback that they permit easy passage therethrough of submicron or smaller dust to be blocked. On the other hand, in the case of a filter made of a porous sintered metal or ceramic, it is technically difficult to make its filtration pores fine and uniform because fusion between pores occurs during the production of the filter. Pores larger than the diameter of dust to be blocked, pores smaller than necessary, closed pores, etc. may be co-present in such a filter, causing problems such as a high pressure loss during ventilation and unstable filter performance.

On the other hand, an EUV exposure apparatus is hugely expensive, costing tens of billions of yen. In addition, vacuuming and returning to atmospheric pressure upon carrying-in/carrying-out of a mask, which are of no direct use to production, but are essential for the operation of the exposure apparatus, constitute a significant dead time of the apparatus and cause an increase in cost. Therefore, in order to increase the operating rate of an EUV exposure apparatus even if only a little and to thereby reduce the production cost, the vacuuming and returning to atmospheric pressure are required to be performed at a higher speed so as to reduce time of such operations.

However, ultra-thin rigid films having a submicron or smaller thickness, made of an inorganic material such as monocrystalline silicon, polycrystalline silicon, or amorphous silicon, or a nitride, oxynitride or carbide thereof, are commonly used as current pellicle films for EUV exposure from the viewpoint of resistance and permeability to EUV light and from the viewpoint of processability.

When the above-described vacuuming and returning to atmospheric pressure are performed at a high speed using a pellicle attached to a mask and having a current filter with a high pressure loss or a filter whose size has been forcibly reduced to meet dimensional limitations due to the structure of an exposure apparatus, rapid inflow or outflow of air into or out of the pellicle causes a pressure loss which produces local air-concentration differences in the space between the mask and the pellicle, thereby producing large local pressure differences. An ultra-thin rigid pellicle film cannot follow such pressure differences; the pellicle film will be broken and scatter, contaminating the interior of an expensive exposure machine. This makes it impossible to perform subsequent exposure operations, thus causing enormous loss. This problem is a big bottleneck in the EUV exposure technology.

To address the problem, prior art, for example Patent Document 1, proposes covering a circuit pattern with a mask cover (reticle cover) that serves both as a so-called pellicle film and as a vent filter to protect the circuit pattern from dust. This method allows an exposure surface to contribute to a filter area, and therefore is substantially free of dimensional limitations due to the structure of an exposure apparatus. Thus, this method allows for an extremely large filter area and enables high-speed vacuuming and returning to atmospheric pressure. On the other hand, however, in a portion which serves both as an exposure surface and as vent holes of a filter and which is directly irradiated by EUV light, a porous fluororesin (PTFE resin) as described in the document is directly irradiated by high-energy EUV light. Even the PTFE, which has relatively good light resistance, will decompose and cannot withstand even short-term use. This prevents the practical use of such a reticle cover.

### Solution to Problem

The present inventors have made intensive efforts to solve the above-described bottleneck and various problems, resulting in completion of the present invention. Thus, the present invention can be embodied as follows.
[1] A pellicle comprising:
   a pellicle frame;
   an ultra-thin pellicle film provided on an upper end surface of the pellicle frame;
   a vent hole provided in the pellicle frame; and
   a filter that closes the vent hole,
   wherein the filter comprises a sheet composed partly or entirely of at least one of nanofibers and carbon nanotubes, and a support having openings and supporting the sheet.
[2] The pellicle as set forth in [1] above, comprising:
   a pellicle frame;
   an ultra-thin pellicle film provided on an upper end surface of the pellicle frame;
   a vent hole provided in the pellicle frame; and
   a filter that closes the vent hole,
   wherein the filter comprises a non-woven fabric composed partly or entirely of at least one of nanofibers and carbon nanotubes, and a support having openings and supporting the non-woven fabric.
[3] The pellicle as set forth in [1] or [2] above, wherein the non-woven fabric is composed of at least nanofibers and/or carbon nanotubes (CNTs) produced by electrospinning.
[4] The pellicle in any one of [1] to [3] above, wherein the support has a flat plate-like shape.
[5] The pellicle in any one of [1] to [4] above, wherein the support has a honeycomb structure.
[6] The pellicle as set forth in any one of [1] to [5] above, wherein the filter includes the non-woven fabric and the support having openings and has a "filtration accuracy gradient"* in a direction from one surface toward the opposite surface or in a direction from both surfaces toward a central plane.
   (*"filtration accuracy gradient" herein refers to a gradual change in the filtration accuracy of a filter material. Generally, the filter is configured to capture particles in order of gradually decreasing diameter to prevent rapid clogging of the filter.)
[7] The pellicle as set forth in any one of [1] to [6] above, wherein the pellicle film has a thickness of 1 um or less, and is partly or entirely made of at least monocrystalline silicon, polycrystalline silicon, or amorphous silicon, or a nitride, oxynitride, or carbide thereof, or a metal silicide.
[8] The pellicle as set forth in [7] above, wherein the pellicle film has a coating of an inorganic compound.
[9] The pellicle as set forth in [8] above, wherein the inorganic compound is SiC, Si₃N₄, or Y₂O₃.
[10] The pellicle as set forth in any one of [1] to [9] above, wherein the surfaces of the nanofibers or the carbon nanotubes are coated with SiC or Si₃N₄.
[11] The pellicle as set forth in any one of [1] to [10] above, wherein the pellicle is a pellicle for EUV masks.
[12] An exposure mask with a pellicle, comprising an exposure mask, and the pellicle in any one of [1] to [11] above, mounted on the exposure mask.
[13] A method for producing the pellicle in any one of [1] to [12] above, comprising the steps of: producing a non-woven fabric composed of at least one of nanofibers produced by an electrospinning method and carbon nanotubes produced by a carbon nanotube method; and producing a filter using the non-woven fabric and the flat plate-like support having openings.
[14] The method for producing the pellicle in [13] above, wherein the flat plate-like support has a honeycomb structure.
[15] An exposure method comprising performing exposure using the exposure mask with the pellicle in [13] or [14] above.
[16] A method for manufacturing a semiconductor device, comprising a step of performing exposure using the exposure mask with the pellicle in [13] or [14] above.

### Advantageous Effects of Invention

The present invention makes it possible for the first time to achieve an ultra-thin, compact, and high-performance filter in a pellicle for exposure, especially in a pellicle for leading-edge EUV exposure which is subject to severe space limitations upon its mounting. Thus, it is now possible for the first time to perform complete mounting of a pellicle which has been difficult until now. Since the filter of the present invention comprises the above-described non-woven fabric and support, it can prevent entry of fine foreign matter having a submicron or smaller size despite the extremely small pressure loss in the filter. In addition, the filter makes it possible to perform the so-called "atmospheric pressure adjustment", i.e. vacuuming and returning to atmospheric pressure upon carrying-in/carrying-out of a mask, at a higher speed, thereby increasing the operating rate of an expensive exposure apparatus. This makes it possible to achieve the production of a high-performance semiconductor device at a significantly reduced production cost.

### Brief Description of Drawings

FIG. 1 is a vertical sectional view showing an embodiment of an exposure mask with a pellicle according to the present invention.
FIG. 2a is a diagram illustrating an embodiment of a support for use in the present invention, the support being a flat plate-like mesh having (a) round openings.
FIG. 2b is a diagram illustrating an embodiment of a support for use in the present invention, the support being a flat plate-like mesh having (b) quadrangular (square) openings.
FIG. 2c is a diagram illustrating an embodiment of a support for use in the present invention, the support being a flat plate-like mesh having (c) honeycomb openings.

### Description of Embodiments

Embodiments of the present invention will now be described in detail with reference to the drawings.

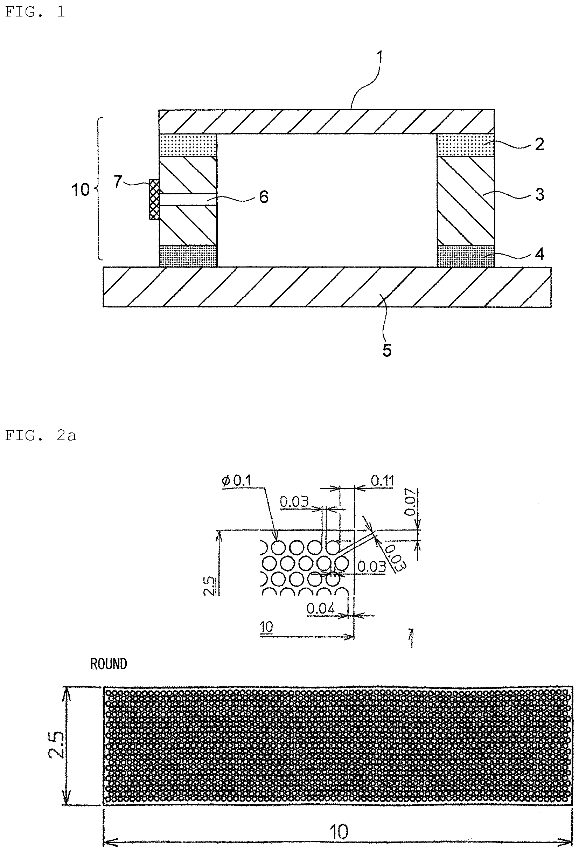

As shown in FIG. 1, the pellicle 10 for exposure of the present invention includes a pellicle frame 3, an ultra-thin pellicle film 1 provided on the upper end surface of the pellicle frame 3 via an adhesive layer 2, and at least one vent hole 6 provided in the pellicle frame 3. The vent hole(s) is closed by a filter 7 which functions to prevent entry of foreign matter and which is formed of a sheet or non-woven fabric, composed partly of nanofibers and/or carbon nanotubes (CNTs), and a support having openings and supporting the sheet or non-woven fabric.

However, apart from ordinary exposure masks and pellicles, EUV exposure masks, and especially EUV pellicles are given only an extremely small space due to the structure of an EUV exposure apparatus. Therefore, filters for EUV pellicle are necessarily required to be small and extremely thin. However, in EUV exposure, for which even submicron foreign matter is not allowed, conventional filters for prevention of foreign matter, composed of a non-woven fabric having a thick fiber diameter and a thick support formed of woven thick fibers and having an overlapping portion, can no more capture submicron foreign matter or be housed in an extremely small space.

The present inventors have made intensive studies to improve such a filter, and accomplished the present invention. Thus, according to the present invention, an improvement is made by the use of a sheet or non-woven fabric, which is composed partly of nanofibers and/or carbon nanotubes (CNTs), in combination with a support for the non-woven fabric, which has been obtained by processing a flat plate of metal or resin to form openings of any desired shape and which is free of overlapping of fibers.

In particular, a filter for a pellicle for exposure 1) which has a reduced overall size and is extremely thin, and therefore can meet a narrow space, 2) which can prevent entry of ultrafine foreign matter having a submicron or smaller size, and 3) which causes a reduced pressure loss and can perform atmospheric pressure adjustment at a high speed, is achieved by performing the following features (1) to (4) singly or in a combination of two or more: (1) to use, as a filter material that captures foreign matter having a submicron or smaller size, a sheet or non-woven fabric composed partly of nanofibers and/or carbon nanotubes (CNTs) of the present invention, and (2) to provide openings in an ultra-thin flat plate made of a metal, such as SUS or Ni, or a resin, and integrate the plate with an ultra-thin support to make a filter and, optionally, in order to make the support have a higher opening ratio and to address reduction in the strength of the ultra-thin support, (3) to design the openings so that they have a honeycomb structure, and (4) to make the filter, including the non-woven fabric and the support having openings, have a "filtration accuracy gradient"* in a direction from one surface toward the opposite surface or in a direction from both surfaces toward a central plane (*"filtration accuracy gradient" herein refers to a gradual change in the filtration accuracy of a filter material. Generally, the filter is configured to capture particles in order of gradually decreasing diameter to prevent rapid clogging of the filter.). Of course, it is most preferred to perform all the features (1) to (4) because of the maximum synergistic effect thereof. Owing to the increase in the operating rate of an EUV exposure apparatus and the increase in the productivity, achieved by implementation of the present invention, let alone enhancement of properties of a product, a significant cost reduction is now possible.

Methods for processing the above-described openings include physical pressing and chemical etching. Etching is preferred because it allows for more precise processing. In FIG. 1, the filter 7 is located outside the outer opening of the vent hole 6. However, as necessary, the outer opening of the vent hole 6 may be provided with a counterbore in which the filter 7 is partly or entirely embedded. In order to reduce the generation of dust from a peripheral portion of the pellicle frame 3 and to prevent the generation of dust upon contact between the filter 7 and a peripheral portion around the vent hole 6, at least one of the outer opening and inner opening of the vent hole 6 may be chamfered. The pellicle frame 3 generally has a frame-like shape (usually square) corresponding to the shape of a mask 5.

The above-described non-woven fabric refers to "a fiber sheet, web or batt, in which the fibers are oriented in one direction or randomly, and are bound by interlacing and/or fusion and/or adhesion, excluding paper, a woven fabric, a knitted fabric, a tuft, and a carpet felt.", as described in JIS L-0222:2001. In the present invention, the filter need not necessarily be a non-woven fabric; it suffices if the filter is a sheet. It is preferred that the sheet be partly or entirely composed of at least one of nanofibers and carbon nanotubes (CNTs) in a sheet form, and that the nanofibers or the carbon nanotubes (CNTs) be entangled.

The nanofibers and carbon nanotubes (CNTs), constituting a part or the whole of the sheet or non-woven fabric, may be at least nanofibers produced by electrospinning and carbon nanotubes (CNTs) produced by one of various CNT synthesis methods.

Fibers produced by a drawing method are generally used in a common non-woven fabric production method. The average fiber diameter of such fibers is as large as several micrometers or more. Further, the diameters of the fibers may vary greatly depending on the drawing force applied; the fibers may have a wide diameter distribution. Accordingly, the foreign matter capture rate and the strength of the resulting non-woven fabric may not be constant. The non-woven fabric will not sufficiently capture foreign matter having a submicron or smaller size, and thus does not meet the object of the present invention. In the present invention, nanofibers produced by a so-called electrospinning method, which provides a non-woven fabric having relatively constant strength and foreign matter capture rate and which easily produces ultra-thin fibers having a nanometer diameter, and carbon nanotubes produced by a method selected from various CNT production methods may be used. The use of a non-woven fabric, which is produced with the use of such nanofibers, is essential for the present invention. The diameter of nanofibers is not particularly limited in the present invention as long as it is on the order of nanometers; however, it is generally 1 um or less, and preferably in the range of 10 to 950 nm. This is because fibers having a diameter of less than 10 nm have a too-low strength, and therefore are difficult to handle. On the other hand, it is difficult for fibers having a diameter of more than 950 nm to remove foreign matter having a submicron or smaller size.

As described above, it is preferred to make the filter, including the non-woven fabric and the planar support, have a "filtration accuracy gradient", through the use of thinner nanofibers and thicker nanofibers or with the openings of the planar support, in a direction from one surface toward the opposite surface or in a direction from both surfaces toward a central plane. This is because a non-woven fabric, composed solely of thin nanofibers having a constant diameter, has a high foreign matter capture rate. However, the filter strength of the non-woven fabric is low; it breaks easily and cannot withstand long-term use. On the other hand, the gradual "filtration accuracy gradient", created by using relatively thick nanofibers at one surface or at both surfaces, and gradually decreasing the average diameter of nanofibers in a direction from the one surface toward the opposite surface or in a direction from both surfaces toward a central plane, or by the openings of the planar support, can increase the filter strength and the foreign matter capture rate, and can reduce the pressure loss. It therefore becomes possible to perform vacuuming and returning to atmospheric pressure at a higher speed upon carrying-in/carrying-out of an exposure mask.

Thus, a gradual "filtration accuracy gradient" is formed by thicker nanofibers or by the opening degree of the planar support. Thinner nanofibers mainly serve to remove foreign matter having a submicron or smaller size, while thicker nanofibers or the planar support serve to remove larger foreign matter. In addition, such thicker nanofibers and the planar support are favorably complementary to each other and both serve as strength reinforcing materials.

In the present invention, when it is intended to perform vacuuming and returning to atmospheric pressure at a higher speed, rather than solely using nanofibers for the filter, it is possible to intentionally add thereto fibers having a diameter of a few micrometers or more in an amount of 5 to 70 vol %, as necessary, to increase the strength of the filter so that it can withstand wind pressure upon vacuuming and returning to atmospheric pressure. If the amount of the fibers having a diameter of a few micrometers or more is less than 5 vol %, the strength of the filter is not so high that it is difficult to achieve a considerable speed-up of vacuuming and returning to atmospheric pressure. On the other hand, if the amount is more than 70 vol %, the rate of capture of fine foreign matter having a submicron or smaller size will be undesirably low, though the strength of the filter is increased.

When nanofibers are mixed with the thick fibers having a diameter of a few micrometers or more, the thick fibers are preferably polymer fibers having a high bending strength, such as polypropylene, polyester or polycarbosilane fibers. This is because such polymer fibers act like reinforcing bars in a reinforced concrete structure, and can protect the coexisting nanofibers and the entire filter from being destroyed by a high wind pressure upon high-speed vacuuming or returning to atmospheric pressure. The nanofibers of the present invention, in particular inorganic nanofibers such as silica nanofibers or CNTs, have a brittle and chemically active surface, and are therefore easily lost or damaged depending on the ambient gas. Therefore, the surfaces of such nanofibers may be modified with SiC, Si₃N₄, or the like.

In an exemplary EUV pellicle, an ultra-thin silicon pellicle film 1, having a thickness of 1 µm or less and having a frame-like shape (usually square) corresponding to the shape of the mask 5, is stretch-mounted on the upper end surface of the pellicle frame 3 via the adhesive layer 2. The silicon pellicle film is preferably made of monocrystalline silicon, polycrystalline silicon, or amorphous silicon, or a nitride, oxynitride, or carbide thereof, or a metal silicide. Such a silicon material is selected, for example because compared to various metals and inorganic compounds, thin films of the various crystal forms or of the various silicon compounds are relatively strong and have a high EUV permeability, and a high-purity film can be produced easily and economically. To prevent cracking and corrosion, the pellicle film 1, made of the above-described silicon, or a nitride, oxynitride, or carbide thereof, or a metal silicide, more preferably has a coating of an inorganic compound such as SiC, Si₃N₄, or Y₂O₃. If the thickness of the pellicle film exceeds 1 um, the transmittance for exposure light will be insufficient. Therefore, the film thickness is preferably 1 um or less, more preferably 100 nm to 1 µm.

As described above, the vent hole 6 for atmospheric pressure adjustment, provided in the pellicle frame of the present invention, is closed by the filter 7 for preventing entry of foreign matter, comprising a non-woven fabric composed partly or entirely of at least one of nanofibers and carbon nanotubes, and the support having openings and supporting the non-woven fabric. In particular, for the filter, the non-woven fabric is composed of at least nanofibers produced by electrospinning and/or carbon nanotubes (CNTs). In addition, the support has a flat plate-like shape and, as necessary, has a honeycomb structure.

Conventional non-woven fabric filters are no longer able to remove foreign matter such as ultrafine dust, which is problematic for recent highly fine, ultra-high definition circuit patterns of the order of submicrons to several nanometers. Various improvements that have been proposed thus far, for example porous sintered metal or ceramic filters, may be able to achieve size reduction. However, due to variations in adjustment of the particle size of a metal, a ceramic, or the like and in temperature control during sintering, it is difficult to adjust the pore size distribution of such a filter, causing problems such as low foreign matter capture rate and poor reproducibility of pressure loss.

The above problems can be solved by the present invention. Therefore, the pellicle of the present invention can be advantageously used, let alone as a pellicle for conventional use, also as a pellicle for a leading-edge ultrafine mask, especially a pellicle for an EUV mask. In particular, foreign matter of the order of submicrons to several nanometers can be captured with high efficiency by the filter of the present invention.
Further, the filter can be made small-sized and ultra-thin. In addition, the pressure loss upon inflow/outflow of air or a gas can be reduced. Therefore, an EUV exposure mask with the pellicle having the filter makes it possible to perform vacuuming and returning to atmospheric pressure at a higher speed upon carrying-in/carrying-out of the mask. It therefore becomes possible to reduce the dead time of an EUV exposure apparatus, thereby increasing the operating rate of the exposure apparatus and reducing the production cost.

While there is no particular limitation on the opening area of the vent hole(s) 6 for atmospheric pressure adjustment, it is preferably 2% or more of the total area of the lower end surface of the pellicle frame and, in order to enable higher-speed vacuuming and returning to atmospheric pressure and to thereby enable a further reduction in the production cost, it is more preferably not less than 10% and not more than 50%. The upper limit of the opening area of the vent hole(s) depends on the strength of the pellicle frame. If the opening area is too large, the pellicle frame will be deformed, and therefore a circuit pattern will be distorted undesirably. Thus, the upper limit of the opening area should preferably be determined depending on the type of the pellicle frame.

### Examples

An outline for mounting the pellicle of the present invention to a exposure mask will be described again using FIG. 1. An agglutinant 4 for mounting the pellicle 10 to a mask is formed on the lower end surface of the pellicle frame 3. A liner (not shown) for protecting the surface of the agglutinant is provided on the lower end surface of the agglutinant 4. When mounting the pellicle to the mask, the liner is detached to expose the agglutinant, and it is attached to the mask.

The following examples and comparative examples illustrate the present invention in greater detail and are not intended to limit the scope of the invention.

### [Example 1]

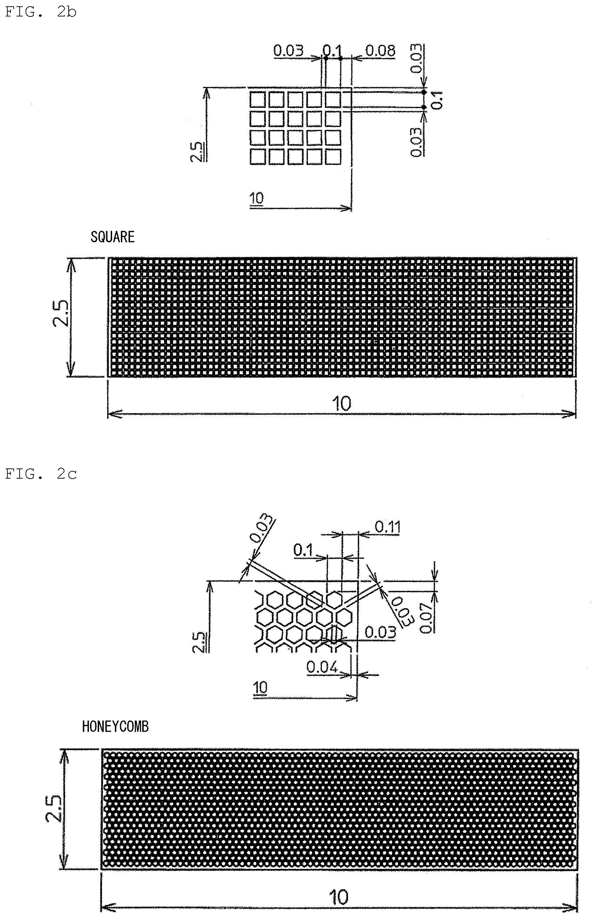

A 150-um thick non-woven fabric having a "filtration accuracy gradient" was produced by mixing polypropylene fibers having an average diameter of 3 um, produced by a common method, and silica fibers having an average diameter of 0.15 um, produced by electrospinning, at gradually varying mixing ratios such that the average fiber diameter was 0.8 um at both end surfaces of the filter and 0.30 um in a central area of the filter (the average fiber diameter was calculated from an SEM image). At both ends of the non-woven fabric, three-types of supports as shown in FIG. 2, each formed of a flat plate-like mesh (produced by etching a 25-µm thick flat plate of SUS316) having a size of 2.5 mm x 10 mm, having three patterns of openings: (a) round openings (opening ratio: 50.1%); (b) square openings (opening ratio: 57.8%); and (c) honeycomb openings (opening ratio: 55.3%) were produced. The three patterns of openings had the same line width of 30 um and approximately the same opening ratios. The above non-woven fabric, having the same size as each support, was sandwiched between two supports of the same type to produce a filter. The filter, in which the non-woven fabric composed of the nanofibers is combined with the meshed flat plate-like support, has a so-called "filtration accuracy gradient" which is formed in the non-woven fabric and allows the filter to capture particles of foreign matter in order of gradually decreasing diameter to prevent rapid clogging of the filter. Further, due to the combination with the above-described support, an additional "filtration accuracy gradient" is added by the support to the filter. This makes it possible to achieve improved capture of foreign matter and an increased reduction in pressure loss as described below.

28 vent holes for atmospheric pressure adjustment of a pellicle frame as shown in FIG. 1 (total opening area = 450 mm², 21% of the area of the lower end surface of the pellicle frame, allowable filter installation height = 200 µm, allowable height according to an actual EUV apparatus), over which a 0.1-pm thick molybdenum silicide film was stretched, were each able to be completely closed by each of the above filters having a height of 200 um. The pellicle frame was then attached to an exposure mask with an adhesive.

Thereafter, the exposure mask was mounted in a simulated EUV apparatus. NaCl was treated in an atomizer to generate fine NaCl particles, and the particles were subjected to classification using an electrostatic classifier to obtain fine NaCl particles having a size of 0.01 to 0.5 um, which were used as a pseudo-foreign matter atmosphere. While introducing the pseudo-foreign matter atmosphere into the simulated EUV apparatus, a simulation of atmospheric pressure adjustment, i.e. vacuuming and returning to atmospheric pressure, assuming operations upon carrying-in/carrying-out of a mask, was performed. After vacuuming, 1) the foreign matter capture rate, 2) the maximum pressure loss, and 3) the displacement of filter (strength index) upon the maximum pressure loss upon returning to atmospheric pressure were measured for a rough evaluation of the filters. The foreign matter capture rate was 100% for all the fine particles having a size of 0.01 to 0.5 um. The maximum pressure loss was approximately the same low pressure loss of 0.5 to 0.6 Pa for all the three filter opening patterns at a linear velocity of 0.15 cm/s. The maximum displacement of filter upon the maximum pressure loss was 28 um, 45 µm, and 5 um for (a) round openings (opening ratio: 50.1%), (b) square openings (opening ratio: 57.8%), and (c) honeycomb openings (opening ratio: 55.3%), respectively. The data indicates that the three filter opening patterns are all practically usable. Among them, the displacement of the filter having the honeycomb openings was as small as 1/6 to 1/7 of that of the filter having the round or square openings, indicating that the former filter enables higher-speed atmospheric pressure adjustment.

For confirmation, the above filters were used also as filters for atmospheric pressure adjustment of a pellicle frame, over which a 0.1-pm thick molybdenum silicide film was stretched, in the simulated EUV exposure apparatus. The filters were able to fully withstand high-speed atmospheric pressure adjustment without breakage of the molybdenum silicide pellicle film. Due to space limitations, complete mounting of conventional filters to a pellicle has been difficult. In contrast, filters for use in the present invention can be completely mounted to a pellicle. The present invention achieves a pellicle for exposure which can perform atmospheric pressure adjustment at a higher speed.

### [Comparative Example 1]

A non-woven fabric having a thickness of 150 um as in Example 1 was prepared by a common non-woven fabric production method using polypropylene fibers having an average diameter of 3 um. For comparison, at both ends of the non-woven fabric, a meshed support having a size of 2.5 mm x 10 mm was produced which had square openings having the same line width of 30 um and approximately the same opening ratio as in Example 1, produced by braiding ϕ30-µm SUS316 ultrafine wires using a conventional method. The non-woven fabric was sandwiched between two such supports to produce a filter.

The filter obtained was not a thin planar filter, but a thick filter having a thickness of 310 um and having surface irregularities, consisting of peaks and valleys.

This is because the square-mesh support was produced by braiding ultrafine wires, which inevitably resulted in the formation of "peaks and valleys", or irregularities, due to the braiding of ultrafine wires. Thus, it was difficult to produce a small-sized, ultra-thin filter as achieved by the present invention. Accordingly, though it was tried to evaluate the filter obtained in terms of a filter for atmospheric pressure adjustment of a pellicle frame using the same apparatus and the same conditions as in Example 1, the 310-um thick filter was not able to be mounted. Thus, the evaluation was impossible, and the filter could not be used in an actual apparatus.

In an attempt to make at least a rough evaluation, a sample with a widened pellicle frame space of 310 um was prepared, and the simulated EUV apparatus was somewhat modified. The above filter was mounted to the pellicle frame, and a rough evaluation was performed. As a result, it was found that the fibers used were too thick for the intended purpose, and the openings of the non-woven fabric were large. The foreign matter capture rate for the fine particles having a size in the range of 0.01 to 0.5 um was as follows: 27.0% for 0.01 µm; 36.5% for 0.05 µm; 49.4% for 0.10 µm; and 56.0% for 0.5 um. The pressure loss was 11.5 Pa. The two filter characteristics evaluated were very poor for use of the filter in EUV. Further, a pellicle with a 0.1-µm thick molybdenum silicide as a pellicle film was attached to an exposure mask for evaluation. When atmospheric pressure adjustment was performed at the same speed as in Example 1, the pellicle film ruptured during the operation. This may be because the non-planar support, due to the height differences in the peaks/valleys irregularities, cannot evenly support the entire non-woven fabric, causing local pressure differences in the space between the exposure mask and the pellicle film.

### [Example 2]

100% of SiC fibers, produced from polycarbosilane and having an average diameter of 50 µm, were piled up to 50 um to form one end surface. A mixture of CNTs having an average diameter of 35 nm (0.035 um) and the same SiC fibers having an average diameter of 50 um was piled on the one end surface up to 100 um while gradually changing the mixing ratio between the both fibers. Further, 100% of CNTs having an average diameter of 35 nm (0.035 um) was piled up to 30 um to make a non-woven fabric. The non-woven fabric has a three-step "filtration accuracy gradient". As with Example 1 of FIG. 2, a support having a honeycomb structure was produced using a 20-um thick flat Ni plate, and the support was placed on the 30-um thick CNT layer of the non-woven fabric to produce a filter. 28 vent holes (total opening area = 321 mm², corresponding to 15% of the area of the lower end surface of a pellicle frame) for atmospheric pressure adjustment of a pellicle frame as shown in FIG. 1, over which a 0.15-µm thick p-Si film was stretched, were each closed by the filter. The pellicle was then attached to an exposure mask with an adhesive.

Thereafter, the above-described filters were evaluated using the same apparatus and the same conditions as in Example 1.

As a result, the foreign matter capture rate was 100% for all the fine particles having a size of 0.01 to 0.5 um. The pressure loss was 0.15 Pa at a linear velocity of 0.15 cm/s. The p-Si pellicle film was not damaged by the differential pressure, and could sufficiently withstand the vacuuming and returning to atmospheric pressure upon carrying-in/carrying-out of the exposure mask.

### Description of Reference Symbols

- 1: pellicle film
- 2: adhesive
- 3: pellicle frame
- 4: agglutinant
- 5: photomask
- 6: vent hole
- 7: filter
- 10: pellicle

## Claims

1. A pellicle comprising:
a pellicle frame;
an ultra-thin pellicle film provided on an upper end surface of the pellicle frame;
a vent hole provided in the pellicle frame; and
a filter that closes the vent hole,
wherein the filter comprises a sheet composed partly or entirely of at least one of nanofibers and carbon nanotubes, and a support having openings and supporting the sheet.

2. The pellicle according to claim 1, comprising:
a pellicle frame;
an ultra-thin pellicle film provided on an upper end surface of the pellicle frame;
a vent hole provided in the pellicle frame; and
a filter that closes the vent hole,
wherein the filter comprises a non-woven fabric composed partly or entirely of at least one of nanofibers and carbon nanotubes, and a support having openings and supporting the non-woven fabric.

3. The pellicle according to claim 1 or 2, wherein the non-woven fabric is composed of at least nanofibers and/or carbon nanotubes (CNTs) produced by electrospinning.

4. The pellicle according to any one of claims 1 to 3, wherein the support has a flat plate-like shape.

5. The pellicle according to any one of claims 1 to 4, wherein the support has a honeycomb structure.

6. The pellicle according to any one of claims 1 to 5, wherein the filter includes the non-woven fabric and the support having openings and has a filtration accuracy gradient in a direction from one surface toward the opposite surface or in a direction from both surfaces toward a central plane.

7. The pellicle according to any one of claims 1 to 6, wherein the pellicle film has a thickness of 1 um or less, and is partly or entirely made of at least monocrystalline silicon, polycrystalline silicon, or amorphous silicon, or a nitride, oxynitride, or carbide thereof, or a metal silicide.

8. The pellicle according to claim 7, wherein the pellicle film has a coating of an inorganic compound.

9. The pellicle according to claim 8, wherein the inorganic compound is SiC, Si₃N₄, or Y₂O₃.

10. The pellicle according to any one of claims 1 to 9, wherein the surfaces of the nanofibers or the carbon nanotubes are coated with SiC or Si₃N₄.

11. The pellicle according to any one of claims 1 to 10, wherein the pellicle is a pellicle for EUV masks.

12. An exposure mask with a pellicle, comprising an exposure mask, and the pellicle according to any one of claims 1 to 11, mounted on the exposure mask.

13. A method for producing the pellicle according to any one of claims 1 to 12, comprising the steps of: producing a non-woven fabric composed of at least one of nanofibers produced by an electrospinning method and carbon nanotubes produced by a carbon nanotube method; and producing a filter using the non-woven fabric and the flat plate-like support having openings.

14. The method for producing the pellicle according to claim 13, wherein the flat plate-like support has a honeycomb structure.

15. An exposure method comprising performing exposure using the exposure mask with the pellicle according to claim 13 or 14.

16. A method for manufacturing a semiconductor device, comprising a step of performing exposure using the exposure mask with the pellicle according to claim 13 or 14.
